(19) Europäisches Patentamt
European Patent Office
Office européen des brevets

(11) **EP 4 564 023 A1**

(12) **EUROPEAN PATENT APPLICATION**

(43) Date of publication:
04.06.2025 Bulletin 2025/23

(21) Application number: 24214110.9

(22) Date of filing: 20.11.2024

(51) International Patent Classification (IPC):
*G01R 31/08* (2020.01) *G01R 31/11* (2006.01)

(52) Cooperative Patent Classification (CPC):
G01R 31/11; G01R 31/088

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 21.11.2023 US 202318516023

(71) Applicant: Analog Devices International
Unlimited Company
Limerick (IE)

(72) Inventor: ALBERTI ARROYO, Hector Enmanuel
Co. Limerick (IE)

(74) Representative: Yang, Shu
Withers & Rogers LLP
2 London Bridge
London SE1 9RA (GB)

(54) **FAULT DETECTION**

(57) There is provided a method of detecting a fault along a cable or transmission line. In the method, the following steps are performed: obtaining an echo response of the cable or transmission line using time domain reflectometry, TDR, identifying a plurality of reflections in the echo response, generating a representation of the plurality of reflections, normalising one of the representation or a threshold, and determining a fault condition based on the normalised representation. By doing this, the faults can be accurately determined in cables of different lengths.

EP 4 564 023 A1

**Description**

<u>Technical Field</u>

The present disclosure relates to fault detection, and in particular a method of detecting a fault along a cable or transmission line.

<u>Background</u>

Faults may occur along cables or transmission lines, such as ethernet cables. An open fault may occur where there is a break in one or more lines of the cable or transmission line. A short fault may occur where one of the lines of the cable or transmission line comes into contact with the other. Other softer faults may occur when aging, poor construction of the cable or transmission line, mechanical interaction with external objects, humidity, etc, create impedance discontinuities than can affect the signal integrity along the cable or transmission line. It is desirable to detect the occurrence of a fault and its location along the cable or transmission line, allowing the fault to be fixed shortly after the fault is detected and reducing down time of the communication sent over the cable or transmission line.

<u>Summary</u>

There is provided a method of detecting a fault along a cable or transmission line. In the method, the following steps are performed: obtaining an echo response of the cable or transmission line using time domain reflectometry, TDR, identifying a plurality of reflections in the echo response, generating a representation of the plurality of reflections, normalising one of the representation or a threshold, and determining a fault condition based on the normalised representation. By doing this, the faults can be accurately determined in cables of different lengths.

According to a first aspect of the disclosure, there is provided a method of detecting a fault along a cable or transmission line, the method comprising: obtaining an echo response of the cable or transmission line using time domain reflectometry, TDR; identifying a plurality of reflections in the echo response; generating a representation of the plurality of reflections;

obtaining a normalised representation of the representation of the plurality of reflections or obtaining a normalised representation of a fault threshold; and determining a fault condition based on the normalised representation and the other one of the first indication or the fault threshold.

According to a second aspect of the disclosure, there is provided a method of detecting a fault along a cable or transmission line, the method comprising: obtaining an echo response of the cable or transmission line using time domain reflectometry, TDR; identifying a plurality of reflections in the echo response; generating a representation of the plurality of reflections; obtaining a normalised representation of the representation of the plurality of reflections; and determining a fault condition based on the normalised and a fault threshold.

According to a third aspect of the disclosure, there is provided a method of detecting a fault along a cable or transmission line, the method comprising: obtaining an echo response of the cable or transmission line using time domain reflectometry, TDR; identifying a plurality of reflections in the echo response; generating a representation of the plurality of reflections;

obtaining a normalised representation of a fault threshold; and determining a fault condition based on the representation of the plurality of reflections and the normalised representation of the fault threshold.

<u>Brief Description of the Drawings</u>

Aspects of the disclosure will now be described by way of example only and with reference to the accompanying drawings, wherein like reference numerals refer to like parts, and wherein:

    Figure 1 shows a schematic representation of a time domain reflectometry system;
    Figure 2 shows a graph of the echo responses of a number of cables of different lengths;
    Figure 3a shows a flowchart of a method for detecting a fault along a cable or transmission line;
    Figure 3b shows a flowchart of a method for detecting a fault along a cable or transmission line including reflection validation;
    Figure 4 shows a graph of the normalised echo responses of a number of cables;
    Figure 5 shows a reflection of an echo response and an undershoot of the reflection;
    Figure 6 shows a graph of the exponential relationship of cable attenuation;
    Figure 7a shows an impulse response provided by a time domain reflectometer with no cable connected;
    Figure 7b shows an impulse response provided by a time domain reflectometer connected to a cable which is not terminated;

Figure 8 shows a flowchart of a method for obtaining an echo response of a cable;

Figure 9 shows an alternative schematic representation of a time domain reflectometry system;

Figure 10 shows a flowchart of a method for detecting a fault along a cable or transmission line using the system of figure 9;

Figure 11 shows an echo response of the cable of the system of figure 9;

Figure 12A shows a raw echo response from a fault occurring at 0m from the reflectometer, sampled at a sampling frequency Fo;

Figure 12B is a zoomed in version of the reflection depicted in Figure 12A;

Figure 12C shows the polynomial approximation of the sampled reflection at a less than Fo sampling frequency and showing the reduced error in the fault location;

Figure 13 shows a heat map of faults at different locations along the cable or transmission line.

Detailed Description

A time domain reflectometer may be used to measure reflections along a cable. The time domain reflectometer transmits a first signal along the cable and receives an echo response showing a number of reflections. Theoretically, in a perfect cable that is properly terminated there will be no reflections, indicating that there are no faults. Where there is an open or short fault, or an impedance mismatch caused by a softer fault, a reflection will be present.

Some cables or transmission lines allow communication over long distances. For example, the 10BASE-T1L standard enables communication over cables of up to 1km. Detecting the presence of a fault allows the cable to be replaced. However, replacing long cables may be uneconomical, and as such it is valuable to know the location of the fault within the cable, allowing only a short length of cable to be removed and replaced.

There can be a large amount of variation between different cables, even those used for the same standard. This is particularly problematic in long cables, where even a small variation in cable properties, such as a variation in the attenuation per unit length of cable, causes a large variation in the working of the cable.

Where time domain reflectometry is used, these variations in cable properties can cause large variations in the echo response. This results in fault detection accuracy varying depending on the cable used.

The inventors have realised that by normalising the echo response, or a threshold against which the echo response is compared, the accuracy of fault detection can be improved. This allows the system to detect faults in a wide variety of cables, accurately determining the magnitude or type of fault and the location of the fault.

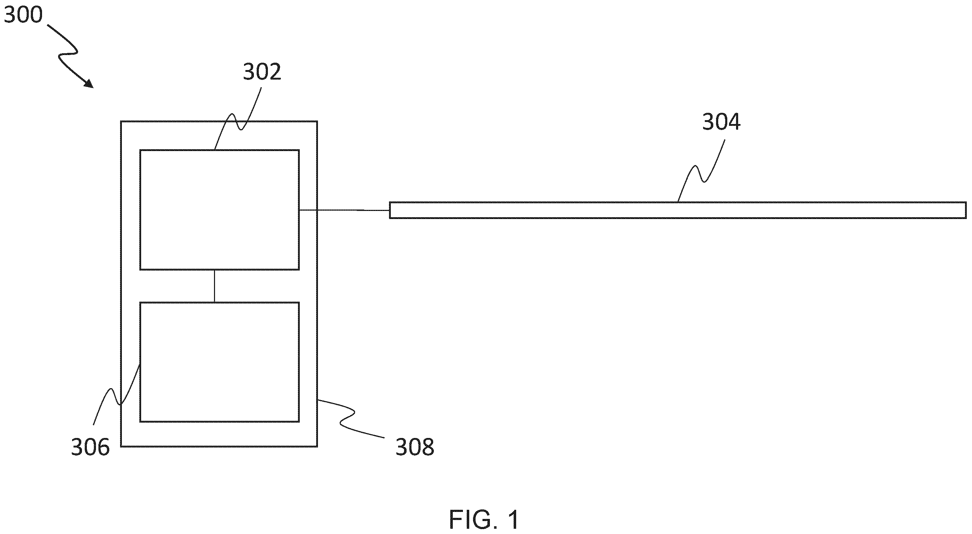

Figure 1 shows a schematic representation of a time domain reflectometry system 300. The system 300 includes a time domain reflectometer 302. The time domain reflectometer 302 may be implemented as part of a larger system. The time domain reflectometer 302 is coupled to a cable or transmission line 304. The time domain reflectometer is configured to output a signal to the cable or transmission line 304 and receive an echo response including reflections. The time domain reflectometer 302 is coupled to a control system 306. The time domain reflectometer provide output the received echo response to the control system 306. The time domain reflectometer 302 and the control system 306 may be part of a system 308 which combines the capabilities of both systems.

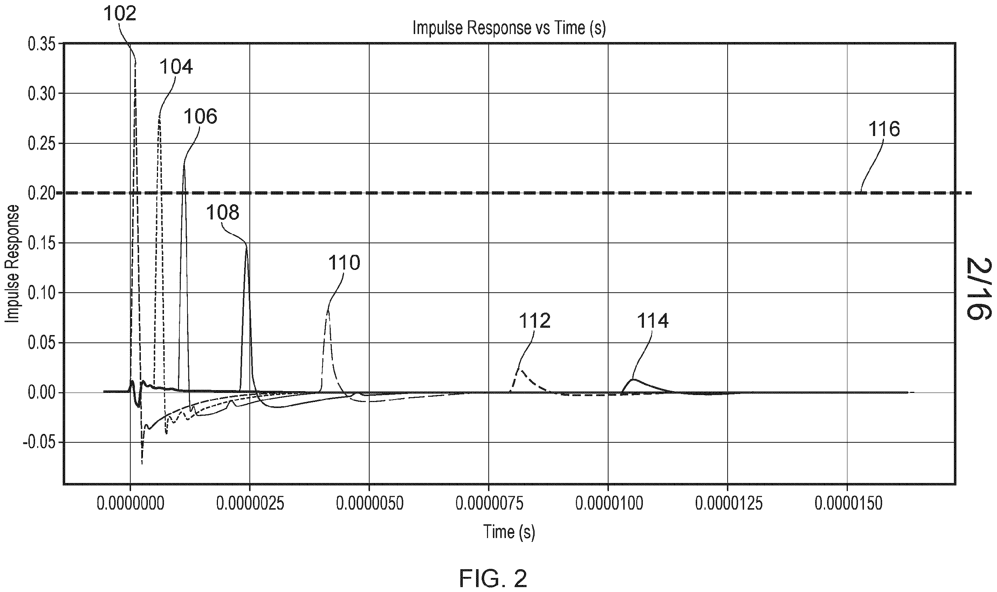

Figure 2 shows echo responses of a number of cables with faults at different locations along the cable 304. The X axis shows the time at which the reflection was detected, with a higher time indicating a greater distance along the cable 304 from the time domain reflectometer 302. The Y axis shows the impulse response or amplitude of the reflection.

The first reflection 102 is detected a first distance from the time domain reflectometer 302. The first reflection 102 represents the reflection provided by a time domain reflectometer when no cable or transmission line is connected to the time domain reflectometer 302.

The remaining reflections shown in Figure 2 represent reflections that occur when a cable 304 with a fault is connected to the time domain reflectometer 302. The location of each fault is located a different distance along the respective cable 304. A second reflection 104 is detected a second distance along the cable 304. A third reflection 106 is detected a third distance along the cable 304. A fourth reflection 108 is detected a fourth distance along the cable 304. A fifth reflection 110 is detected a fifth distance along the cable 304. A sixth reflection is located a sixth distance along the cable 304. A seventh reflection 114 is located a seventh distance along the cable 304.

The attenuation of the cable results in each of the reflections having a different amplitude and shape. The greater the distance the reflection is along the cable from the time domain reflectometer, the lower the peak impulse response or peak amplitude of the reflection. Other factors may also affect the amplitude of the reflection, such as the severity of the fault, the attenuation of the cable per unit of length, the cable's impedance and the cable length. As such, the same fault can look different depending on the length of the cable, the location of the fault and the attenuation of the cable per unit of length. The reflections 104-114 shown in Figure 2 may be indicative of the same fault at different locations along the cable, with the different amplitudes of the reflections caused by the attenuation of the cable.

Reflections may not be representative of a fault event. For example, a reflection may be present due to noise.

Alternatively, faults which are not severe may be tolerated by a communication system, and thus not defined as faults. As such, the reflections may be compared with a fault threshold 116. Where a peak amplitude of a reflection is greater than the threshold 116, the reflection may be determined to represent a fault. For example, the second reflection 104 and the third reflection 106 have an amplitude at their peak which is greater than the fault threshold 116. As such, the second reflection 104 and the third reflection 106 may be determined to represent fault conditions. However, the fourth reflection 108, the fifth reflection 110, the sixth reflection 112 and the seventh reflection 114 have amplitudes at their peak which are less than the threshold. As such, the reflections 106-114 may be determined not to represent a fault condition, even if these reflections are caused by faults.

A threshold 116 may only be able to accurately determine the presence of a fault in a short cable where there is limited insertion loss and where the effect of cable attenuation is minimal on the amplitude of the reflection. However, in some systems, such as in 10BASE-T1L ethernet, the cable may be longer, resulting in faults which provide a reflection with a minimal impulse response. Further, not every reflection may correspond to a fault. As such, an alternative means to determine whether a reflection corresponds to a fault is required.

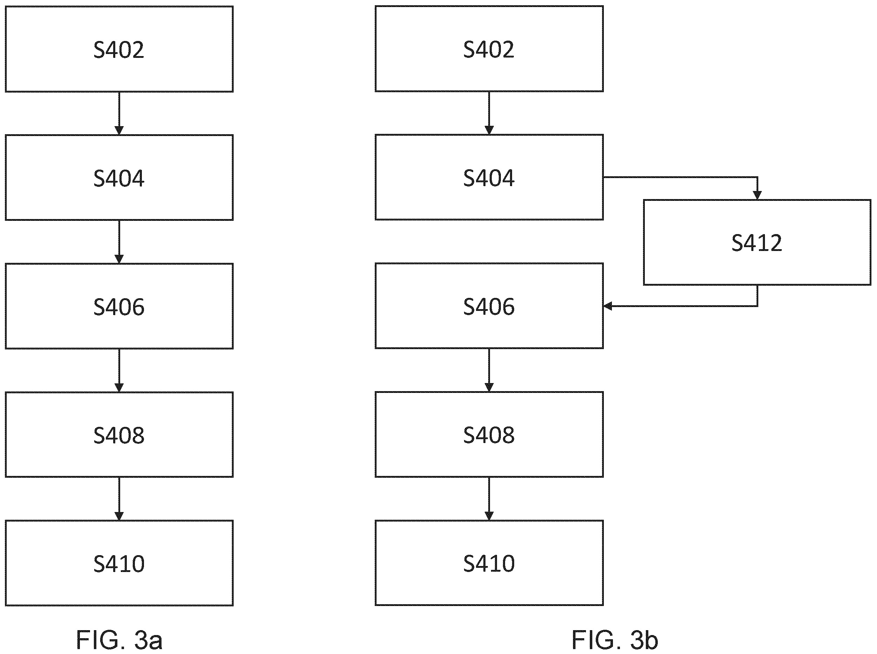

Figure 3a shows a flowchart of a method for detecting a fault along a cable or transmission line.

At step S402, an echo response of the cable or transmission line is obtained using time domain reflectometry.

At step S404, a plurality of reflections are identified in the echo response.

At step S406, a representation of the plurality of reflections is generated. The representation of the plurality of reflections may comprise a first waveform comprising the plurality of reflections, or it may comprise a list of the plurality of reflections and respective sample numbers of the reflections. For example, the sample numbers of the peak, or peak amplitude of the reflection.

At step S408, a normalised representation is obtained. Obtaining the normalised representation may comprise normalising either the reflections of the echo response or the fault threshold against which the reflections are compared. As such, a normalised representation of the representation of the plurality of reflections is obtained, or a normalised representation of a fault threshold is obtained.

At step S410, a fault condition is determined in dependence on the normalised representation of the plurality of reflections and the fault threshold. Alternatively, a fault condition is determined in dependence on the representation of the plurality of reflections and the normalised representation of the fault threshold. For example, a fault is determined by comparing the fault threshold and the peak values of the reflections. Whilst here the reflection is described as a positive reflection, the reflection may have a negative polarity. As such, comparing the peak of a reflection with the threshold may comprise comparing an absolute maximum value of the reflection with the threshold, such that a fault is detected at a sample number where the absolute maximum value of the reflection is above the threshold.

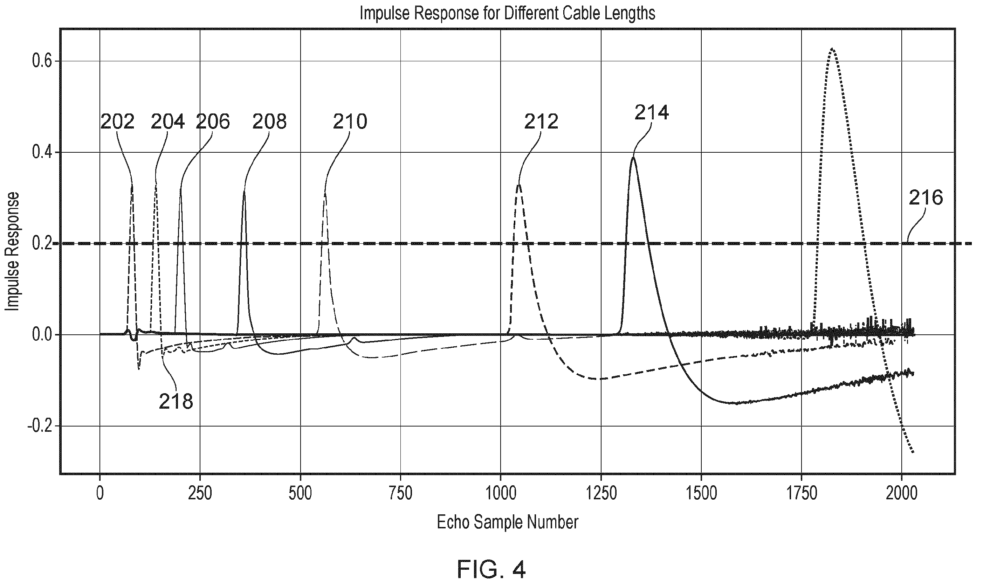

Figure 4 shows echo responses of cables with faults at different locations along the cables. The echo response may be a sampled discrete signal. The X axis shows the sample at which the reflection was detected, with a higher sample number indicating that the reflection occurs a greater distance along the cable from the time domain reflectometer. The Y axis shows the impulse response amplitude at each data point or amplitude of the reflection. Whilst the echo response is sampled, it is clear that the sample number may also be considered to be a time at which the reflection was detected.

The echo responses of Figure 4 are normalised relative to the sample number, representing the normalisation that occurs in step S408 of Figure 3a. This may also be considered to be the same as normalising the echo response against time or a distance from the time domain reflectometer. As such, the reflections 202-214 which represent faults all have a peak amplitude which is greater than the threshold 216. Whilst figure 4 shows the echo responses being normalised, alternatively the threshold 216 may be normalised and the reflections compared with the normalised threshold.

By normalising one of the representation of the plurality of reflections or the fault threshold, the determination of a fault is not dependent on the attenuation of the cable or the length of the cable. This allows accurate fault detection even with long cables.

A reflection generated by an impedance mismatch and indicative of a fault is typically composed of a main reflection peak followed by an undershoot or overshoot. For example, the reflection 204 of figure 4 is followed by an undershoot 218. The undershoot 218 is not representative of a valid fault, and thus may be considered an invalid reflection or a following reflection. As such, it is beneficial to remove these invalid reflections from the analysis of faults.

Figure 3b shows a modified version of the method of figure 3a, further including a step S412. Step S412 comprises validating the plurality of reflections identified in step S404. The representation of the plurality of reflections generated in step S406 is then based off the validated reflections, such that it is a representation of a plurality of validated reflections.

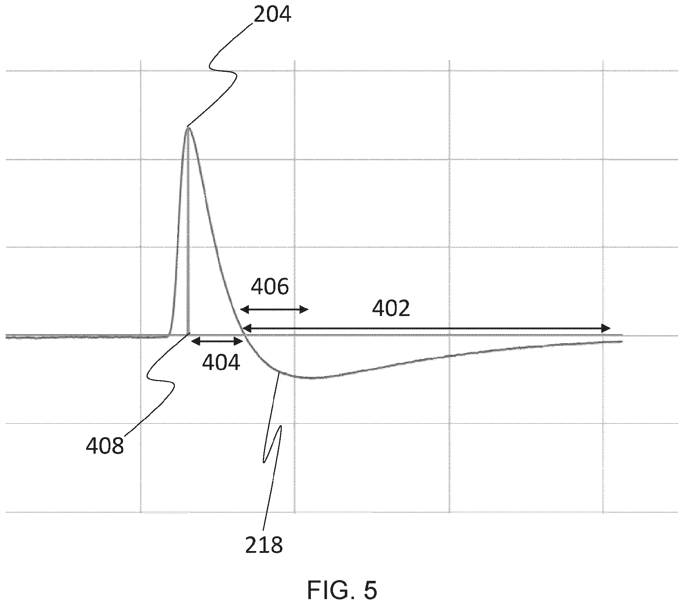

A reflection may be determined to be invalid for a number of reasons. Figure 4 shows the second reflection 204 followed by a reflection 218. Figure 5 shows an alternative view of Figure 4, showing only the second reflection 204 and the following reflection 218.

A reflection may be invalid if the reflection is adjacent to a preceding reflection and of an opposite polarity to the preceding reflection. As is shown in Figure 5, the following reflection 218 has an opposite polarity (negative) to the polarity of the second reflection 204 (positive). Further, the following reflection may be invalid if the following reflection 218 is adjacent to the second reflection 204. Adjacent may mean that a final sample of the first reflection 204 is adjacent to a first sample of the following reflection 218. Adjacent may mean that the final sample of the first reflection and first sample of the following reflection are within a small number of samples of each other. This may be a threshold value, where if the first sample of the following reflection is within a following threshold sample number, then it is considered to be an overshoot or undershoot rather than an independent fault. This following threshold sample number may be determined through experimental testing of cables which include a single fault, to determine how many samples after the final sample of the reflection the following reflection occurs. For example, after the second reflection 204 the echo response of the cable or transmission 304 line may not return to a steady state, but instead may overshoot or undershoot.

The sample at which the reflection crosses the zero-axis or has zero impulse response may define whether a sample is part of the reflection or part of an overshoot or undershoot. The final or end sample of a reflection and the first or start sample of the undershoot or overshoot may be defined as the samples either side of a sample where a zero crossing occurs. Alternatively, the start and end of a may be defined as a sample at which the absolute value of the slope or gradient is below a fraction of the average slope of the reflection. For instance where the slope of a sample or number of samples is $1/4^{th}$ of the average slope of the reflection. Where the polarity of the following reflection has an opposite polarity and is adjacent to a preceding reflection, it may be considered to be caused by an undershoot or overshoot and thus not representative of a fault.

The reflection 218 may also be considered invalid if it has a width 402 that is less than a sample width threshold. The sample width threshold may be defined through calibration based on the type or severity of fault that can be tolerated by a communication system. The sample width threshold may be defined as half the width of the smallest non-tolerable fault's sample width reflection.

The reflection 218 may be considered invalid if the reflection is adjacent to a preceding reflection 204 and has a smaller average starting differential or gradient than the preceding reflections ending differential or gradient. The starting differential of a reflection may be considered to be a gradient of the reflection between a start of the reflection and a peak amplitude of the reflection. The ending differential of a reflection may be a gradient of the reflection between a peak amplitude of the reflection and an end of the reflection. For example, the ending differential of the second reflection 204 is the differential over the sample or time period 404. The starting differential of the reflection 218 is the differential over the sample or time period 406. The peak amplitude of a reflection is the maximum absolute value of the reflection. For example, the peak amplitude of the second reflection 204 occurs at sample number or time 408. As the starting and ending differentials of adjacent reflections may be of opposite polarity, the comparison may be between absolute values of starting and ending reflections.

By considering these factors, it can be determined whether a following reflection is representative of a second fault, or if it is simply an overshoot or undershoot related to a first fault.

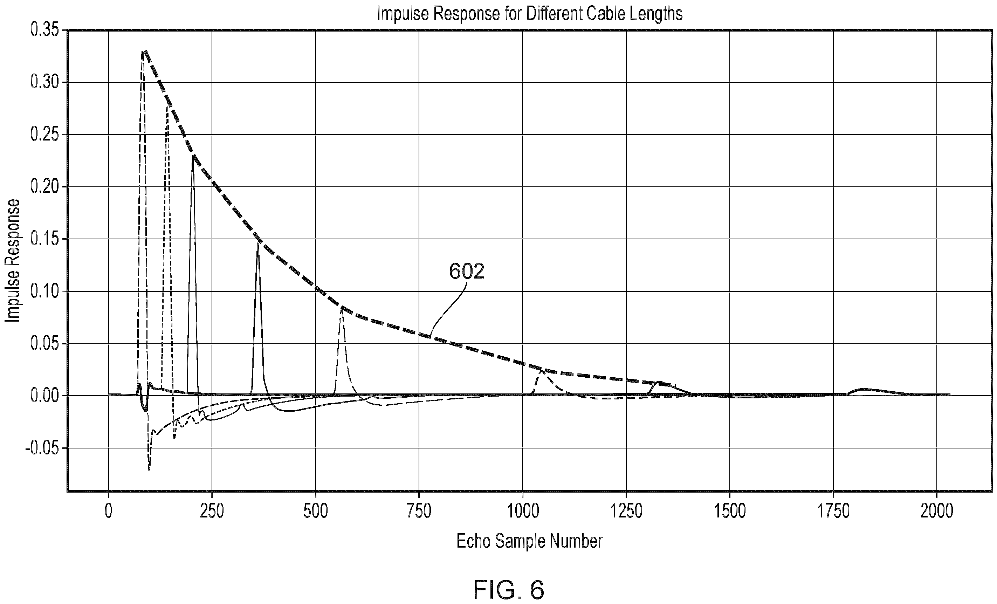

As noted at step S408 of Figure 3a, a normalised representation of the representation of the plurality of reflections is obtained, or a normalised representation of a fault threshold is obtained. Figure 6 shows that the reflections obtained by a time domain reflectometry echo response have a nearly exponential relationship 602 to the time or sample number at which the reflection is received or detected. This is due to the insertion loss of the cable showing an exponential increase as a function of the cable length. This can be seen in the below equations:

Taking the attenuation of cable segment of length $L_0$ to be $A_0$, the attenuation A of a cable of length L at a given frequency f is:

$$A = A_0^{\left(\frac{L}{L_0}\right)} = \left(A_0^{1/L_0}\right)^L = k^L \quad [equation\ 1]$$

The length of the cable may also be represented in terms of the nominal velocity of propagation (NVP) of the cable, where t is the roundtrip time that the signal takes to travel along the length of the cable, reflect and return to the start. L may be considered to be:

$$L = \frac{v_0 * t}{2} \quad [equation\ 2]$$

The received echo response may contain a number of reflections. For a discrete signal, where the received echo response is sampled at a sampling rate with a sampling period $T_s$, the peak amplitude or impulse response of the reflection may occur at sample number n. The round-trip time t from the peak of the reflection can be rewritten as:

$$t = (n - n_0) * T_s = \frac{n - n_0}{F_s} \quad [equation\ 3]$$

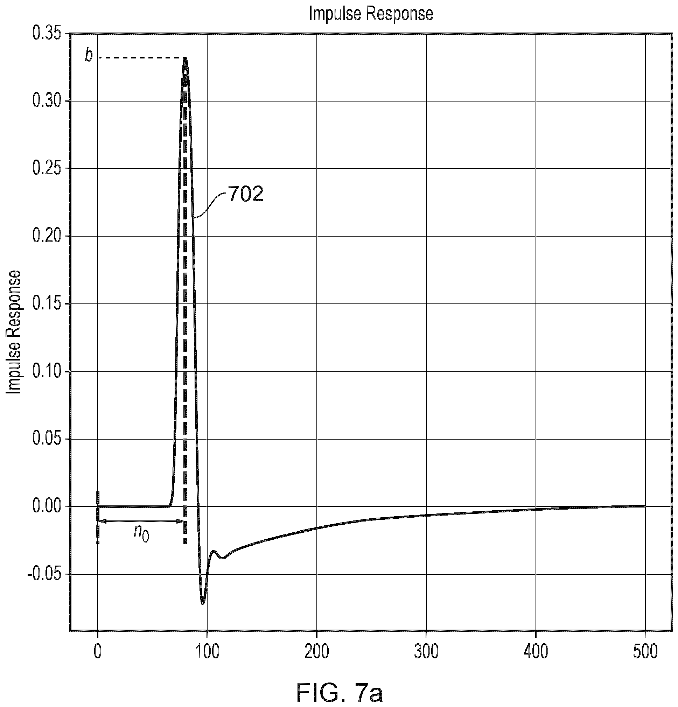

Parameter $n_0$ is the offset of the reflectometer which may be caused by the reflectometer's front end, and it can be deduced from a calibration of the reflectometer, and Fs is the sampling frequency of the discrete signal. Figure 7a shows an example of this parameter, where the response shown in Figure 7a is the echo response obtained by the time domain reflectometer 302 when no cable 304 is attached and the reflectometer is not terminated or left in an open circuit condition. The parameter $n_0$ is therefore the number of samples from the time of transmission of a signal by the time domain reflectometer and a first reflection 702 when no cable is connected to the time domain reflectometer 302. This offset calibration accounts for any delays within the time domain reflectometer 302 and any connections between the time domain reflectometer 302 and the cable 304. Parameter b is the amplitude of the first reflection 702.

As such, for a given frequency, the total attenuation of a cable of length L, is an exponential function of its length, and may be expressed as:

$$A = k^L = k^{\frac{v_0 t}{2}} = k^{\frac{v_0 (n-n_0) T_S}{2}} \quad [equation \ 4]$$

Where $v_0$ is the speed of propagation of the signal and t is the roundtrip time of the signal from one end of the cable to the other. From there A may be expressed as:

$$A = \beta^{(n-n_0)} \quad [equation \ 5]$$

Where $\beta$ is the insertion loss per sample.

As such, each sample n of the echo response may be normalised by multiplying its amplitude or value of that sample by a factor $\beta^{(n-n0)}$. Equation six shows the sample dependent normalization that may be applied to a sample n of the echo response to normalize its amplitude or impulse response. The factor $\beta^{(n-n0)}$ can be easily produced through a cumulative product so that the processing power needed is low.

$$SDN(n) = \beta^{(n-n_0)} \quad [equation \ 6]$$

As such, the normalised representation may be obtained by normalising the representation of reflections to an insertion loss of the cable. Alternatively, the same effect may be achieved by normalising the threshold to an insertion loss of the cable using the inverse function of Equation six.

The normalisation coefficient $\beta$ may be determined based on a reflection received by the time domain reflectometer when the cable is not terminated. $\beta$ is the cable's insertion loss per sample. $\beta$ can be obtained by performing a calibration, attaching a cable of a given type, leaving its farther end open or not connected or shorted and obtaining the cable's TDR response. Beta is calculated as the ratio of the peak corresponding to the open (or short) condition at the end of the cable, and the peak corresponding to the open condition when no cable is attached to the TDR apparatus, this ratio is then elevated to the power of the inverse of the negative difference between their sample locations.

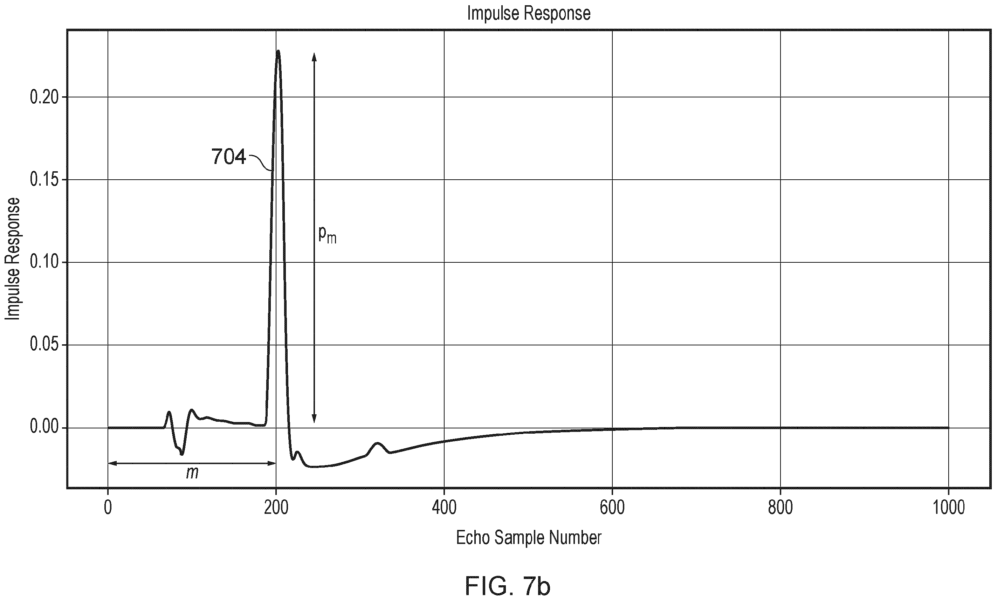

Figure 7b shows the echo response of a cable with an open connection at the end of the cable. A reflection 704 is present due to the cable not being terminated. $P_m$ is the echo response peak or amplitude of the reflection. M is the sample number of where the peak occurs. The amplitude $P_m$ may be represented in terms of the normalisation of equation 6:

$$p_m = b . \beta^{-(m-n_0)} \quad [equation \ 7]$$

$$p_m = b(\beta)^{-(m-n_0)} \quad [equation \ 8]$$

$$\frac{p_m}{b} = (\beta)^{-(m-n_0)} \quad [equation \ 9]$$

$$\left(\frac{p_m}{b}\right)^{\frac{1}{m-n_0}} = \left(\beta^{-(m-n_0)}\right)^{\frac{1}{m-n_0}} \quad [equation \ 10]$$

As such, the normalisation coefficient beta may be determined in accordance with equation 11 with no knowledge of the length of the cable:

$$\beta = \left(\frac{p_m}{b}\right)^{\frac{1}{n_0-m}} \quad [equation\ 11]$$

Obtaining the normalised representation comprises normalising the reflections using a single-point normalisation centred at the frequency or average frequency where the power of a transmitted signal is centred. The normalisation of equation 6 may be applied to the received echo response or its inverse can be applied to the fault threshold against which the echo response is compared.

The reflections are compared in block S410 with a fault threshold. If the peak value of a reflection, which is the maximum amplitude or impulse response of the reflection, is above the fault threshold then the reflection is considered to represent a fault. Whilst the reflections shown in figure 2 are all positive reflections, a representation indicative of a fault may instead be a negative reflection. Reflections may have a positive or negative polarity depending on the fault type, therefore the absolute value of the peak amplitude may be compared with the fault threshold, for example, the absolute value of the minimum or maximum amplitude of the reflection.

The fault threshold may be chosen based on a maximum reflection coefficient, a maximum impedance mismatch or a minimum return loss that can be tolerated by the cable or transmission line. A value that can be tolerated by the cable or transmission line may be a value that the protocol or communication standard that is being used is designed to accept.

As an example, the 10BASE-T1L standard stablishes that the return loss of a given cable must be above 13dB. Hence a threshold corresponding to 13dB return loss can be defined. The reflection coefficient r corresponding to 13dB return loss can be found as:

$$r = 10^{-\frac{Return\ Loss}{20}} = 10^{-\frac{13}{20}} = 0.22387$$

Hence the fault threshold should be defined as

$$R = th/b$$

$$th = r * b = 0.22387 * b$$

Where b is the amplitude of the reflection shown in figure 7b and can be calibrated at the same time as $n_0$ once for a given reflectometer.

Similarly, if the faults to be detected are the ones corresponding to an open or a short condition, this corresponds to a reflection coefficient r = 1, hence the threshold should be close to b, leaving some margin for error.

The examples above show the threshold being chosen exactly at the limit allowed by the standard. However, one may want to provide some headroom for faults to be detected before a fault reaches the limits.

A similar analysis can be done if the threshold is based on impedance mismatches, for instance where instead of return loss the limits are given as tolerance on the nominal impedances of the transmission line. The reflection coefficient can be calculated as:

$$r = \frac{Z_n - 1}{Z_n + 1}$$

$$Z_n = Z/Z_0$$

Zo= characteristic impedance of the line
Z: minimum or maximum impedance tolerated.

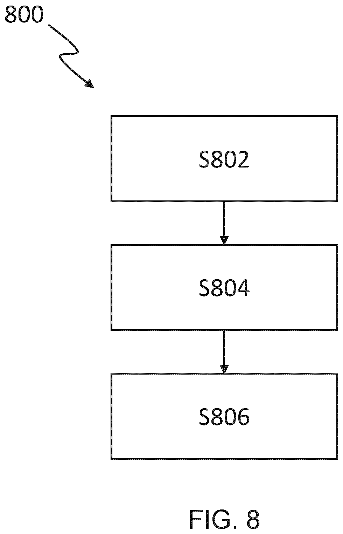

The echo response of the cable 304 is obtained using the time domain reflectometer 302 and provided to the control system 306 in step S402 of Figures 3a and 3b. The echo response may be obtained by the time domain reflectometer 302 in accordance with the method of Figure 8.

The time domain reflectometer 302 is coupled to the cable or transmission line 304. In block S802, the time domain reflectometer 302 transmits a frequency shaped pseudo random sequence of transmission symbols into the cable 304.

In block S804, the time domain reflectometer 302 receives a signal from the cable or transmission line.

In block S806, the time domain reflectometer 302 determines or obtains the echo response of the cable by cross correlating the received signal and the transmitted frequency shaped pseudo random sequence of transmission symbols.

The echo response is constructed point by point by performing a cross-correlation each time. The starting of the sampling of the received signal is delayed by a time Ts, each time to produce a new point of the echo response, hence producing an echo response with a sampling period Ts.

During normal operation of the cable, a communication signal may be transmitted down the cable. The properties of the communication signal depend on the particular standard which the communication protocol is following. The transmitted frequency shaped pseudo random sequence of transmission symbols used to obtain an echo response may have a power spectral density which is the same as, or a scaled version of, the power spectral density of the communication signal which is intended to be used for the cable or transmission line. For example, where the cable or transmission line is intended to be used with the 10BASE-T1L ethernet standard, the power spectral density of the frequency shaped pseudo random sequence of transmission symbols may be matched to that of the power spectral density of a 10BASE-T1L signal described as PMA test mode 3. This ensures that any faults found in the cable or transmission line are faults that would affect the intended communication signal. Other faults which are not represented in the echo response may be considered to be irrelevant to the use of the cable or transmission line for its intended communication.

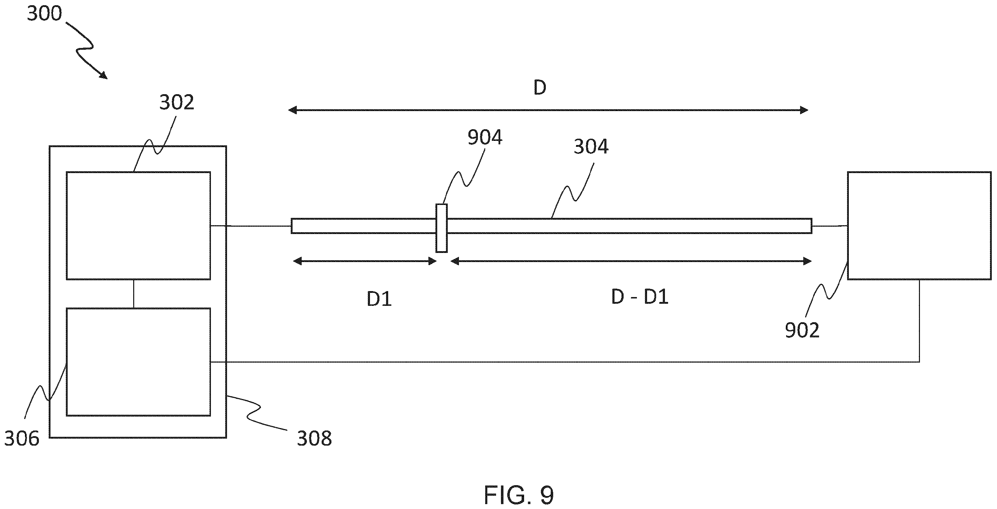

Figure 1 shows a system in which a TDR or echo response of the cable 304 is obtained using a signal time domain reflectometer 302. As is shown in Figure 9, the system 800 may include a second time domain reflectometer 902. The second time domain reflectometer 902 is coupled to a different part of the cable or transmission line 304 compared to the coupling of the first time domain reflectometer 302. For example, the first time domain reflectometer 302 is coupled to a first end of the cable 304 and the second time domain reflectometer 902 is coupled to a second end of the cable 304. The second time domain reflectometer 902 may be used in conjunction with the first time domain reflectometer 302 to provide improved accuracy in fault detection.

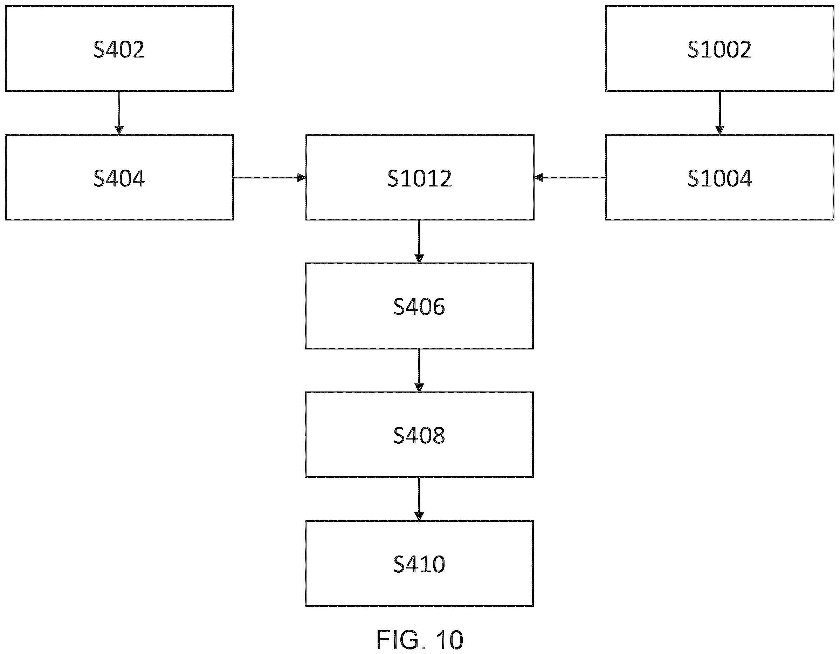

Figure 10 shows a flowchart of a method for detecting a fault along a cable or transmission line using two received echo responses.

At step S402, a first echo response of the cable or transmission line 304 is obtained using time domain reflectometry from a first end of the cable 304. The first echo response may be obtained using the first time domain reflectometer 302.

At step S404, a plurality of reflections are identified in the first echo response.

At step S1002, a second echo response of the cable or transmission line 304 is obtained using time domain reflectometry from a second end of the cable 304. The second echo response may be obtained using the second time domain reflectometer 902.

At step S1004, a second plurality of reflections are identified in the second echo response.

At step S1012, the plurality of reflections identified in the first echo response are validated using the second plurality of reflections identified in the second echo response. The validation may comprise comparing locations of the plurality of reflections in the first echo response with locations of the plurality of reflections in the second echo response. For example, if the first echo response comprises a first reflection and the second echo response comprises a second reflection which corresponds to the first reflection, the first reflection may be considered valid, at least because two separate echo responses of the cable 304 indicate a reflection.

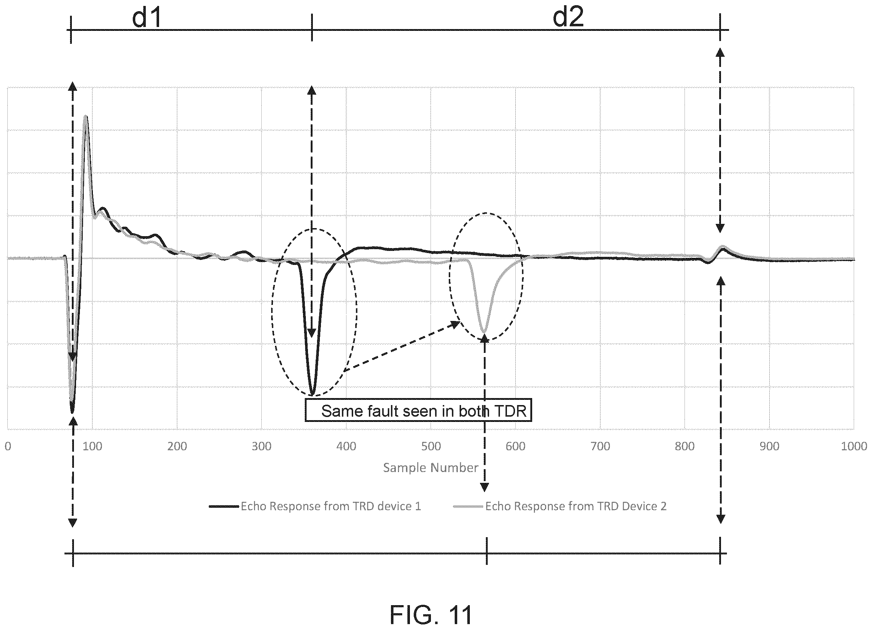

Figure 11 shows an example of the first echo response and the second echo response on a plot with sample number on the X axis and impulse response on the Y axis. The first echo response comprises a first reflection 1102 and the second echo response comprises a second reflection 1104. The first reflection 1102 and the second reflection 1104 occur at different sample numbers of the respective echo responses. This is because the echo responses are obtained from different ends of the same cable 304.

Figure 9 shows a representation of a first fault 904 on the cable 304. Taking D to be the length of the cable or number of samples required to represent the length of the cable. The first fault 904 is a distance or number of samples D1 from the location at which the first echo response is taken 302, the first end of the cable. The first fault 904 is a distance or number of samples D-D1 from the location at which the second echo response is taken 302, the second end of the cable.

As such, the same fault represented by a reflection appears at a different sample number in the first echo response compared to the second echo response. If a first echo response taken from a first end of the cable shows a first reflection 1102 at a distance D1 from the first end of the cable 304, and the second echo response taken from a second end of the cable shows a second reflection 1104 at a distance D-D1 from the second end of the cable 304, then the first reflection 1102 and the second reflection 1104 may be considered to represent the same reflection and the first reflection 1102 is considered valid.

Further, if the first reflection 1102 and the second reflection 1104 have the same polarity they may be considered valid.

As such, in block S1012, reflections in the first echo response are identified and validated through comparison with reflections in the second echo response.

At step S406, a representation of the plurality of validated reflections is generated.

At step S408, a normalised representation of the representation of the plurality of reflections is obtained, or a normalised representation of a fault threshold is obtained.

At step S410 a fault condition is determined in dependence on the normalised representation of the plurality of reflections and the fault threshold. Alternatively, a fault condition is determined in dependence on the representation of the plurality of reflections and the normalised representation of the fault threshold.

Where a first reflection 1102 and a second reflection 1104 are determined to represent the same fault in step S1012, the faults may be used for calibration of the cable and to determine the attenuation of the cable.

The first reflection 1102 has a first amplitude or impulse response 1106, with a value $P_1$, And is observed in the TDR response taken from the Time Domain Reflectometer 302 from Figure 9. The second reflection 1104 in Figure 11, has a second amplitude or impulse response 1108 with a peak value $P_2$, when taken from Time Domain Reflectometer 902. The reflections are found at different distances from the respective time domain reflectometer or end of the cable from which the echo response was obtained. The first reflection 1102 is a distance D1 from the first end of the cable 304. The second reflection 1104 is a distance D-D1 from the second end of the cable 304. Essentially, the two different reflections represent the same fault measured from different points in the cable 304. The amplitude difference between the two reflections is therefore caused by the attenuation of the cable.

Between the first reflection 1102 and the second reflection 1104, the cable 304 attenuates the signal by a ratio of the first amplitude 1106 and the second amplitude. The attenuation corresponds to the attenuation over a length of cable D-(2xD1). As such, where the distance is measured in samples, the attenuation per sample, or the normalisation coefficient β is given by:

$$Attenuation/length = \left(\frac{P_1}{P_2}\right)^{\frac{1}{D-(2*D1)}} \quad [equation \ 12]$$

Which in turn can be expressed as a function of the sample numbers where each peak occurs:

$$\beta = \left(\frac{P_1}{P_2}\right)^{\frac{1}{P_{2idx} - P_{1idx}}} \quad [equation \ 13]$$

This attenuation coefficient β may then be used in the normalisation of the reflections or threshold described earlier. As such, the attenuation or normalisation coefficient β which is used to obtain the normalised representation may be determined in dependence on the ratio of the maximum value of the first reflection 1102 and the second reflection 1104.

Whilst the determination of the normalisation coefficient is described here based on a fault in the cable 904, the determination may instead be determined when there is no fault. For example, a reflection caused by a device to cable junction between the respective time domain reflectometers and the ends of the cable can be used instead. In some scenarios where the cable's characteristic impedance matches the time domain reflectometers output impedance, the reflection caused by the junction may be too small and fail to be determined over the noise of the cable or reduce the accuracy of the determination due to a low SNR. However, if the reflection is too small, this is an indication that there are no faults in the cable.

The preceding description considers an echo response of the system. Whilst the echo response is described as being obtained by a time domain reflectometer, it may instead be obtained by any device capable of transmitting a signal into a cable or transmission line and receiving an echo response from the cable or transmission line. For example, the system may not include a dedicated time domain reflectometer, instead an echo response of the system may be obtained whilst the cable 304 is being used for communication. For example, device 302 may be a communication device capable of transmitting and receiving communication signals. Similarly, the device 902 may be a communication device capable of transmitting and receiving communication signals. The echo response may be obtained using active time domain reflectometry, where the echo response is obtained during communication using the filter coefficients of the echo canceller of a device with such a filter as in the case of some ethernet transceivers.

The representation of the plurality of reflections may comprise a first waveform which comprises the plurality of reflections. Alternatively, it may comprise a list of the plurality of reflections, the list including the sample numbers of the peak of each reflection. The list may further comprise other properties of the reflections, such as a width of the respective reflections; a maximum value of the respective reflections; a location of the maximum value' for the respective reflections; a starting point of the respective reflections; an ending point of the respective reflections; an average starting slope of the respective reflections; and an average ending slope of the respective reflections.

Where a reflection is determined to represent a fault, the location of a fault may be determined based on the sample number at which the peak amplitude of the reflection occurs and the sample frequency:

$$\frac{(Pk_{index} - offset) * c * nvp}{2 * F_s} \quad [equation\ 13]$$

The echo response may be a sampled echo response. As such, the location of the fault may be the sample number at which the peak of the reflection indicating a fault. As the echo response is sampled, the peak may not be accurately represented in the echo response.

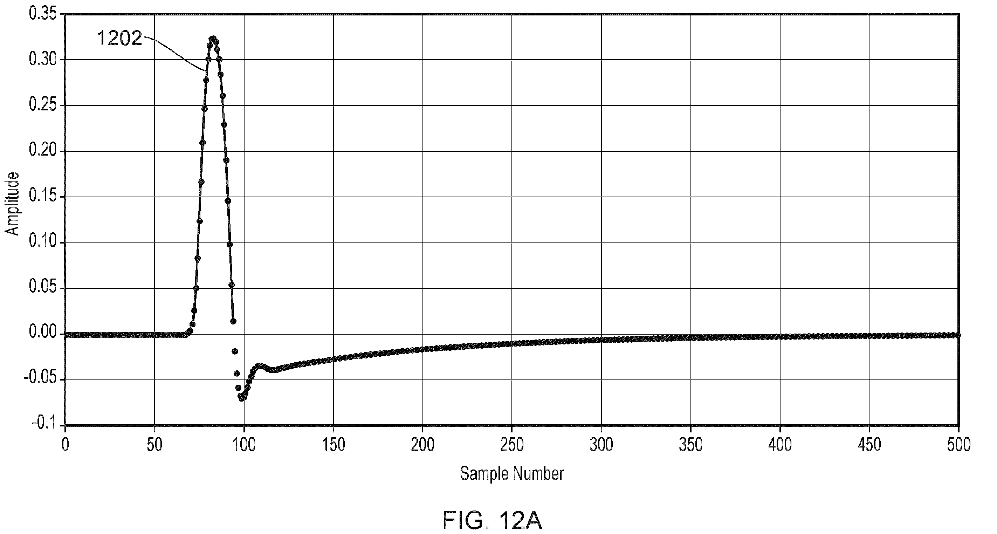

Figure 12A shows an echo response of a fault occurring 0m from the reflectometer sampled at a sampling frequency F0. As can be seen, the reflection 1202 is composed of a number of individual samples (represented by circles on the figure). An approximation of the reflection is provided by a line connecting these samples. Based solely on the samples, the peak impulse response of the reflection is chosen to be the peak impulse response of one of the samples. However, as discussed above, where the sample rate is low, this may not be an accurate representation of the sample.

Polynomial fitting may be used to create a more accurate representation of the location of the peak and the shape of the reflection. Fitting a polynomial function to a reflection of the echo response, then determining a location of the fault based on the sample number or interpolated sample number of a maximum value of the polynomial function.

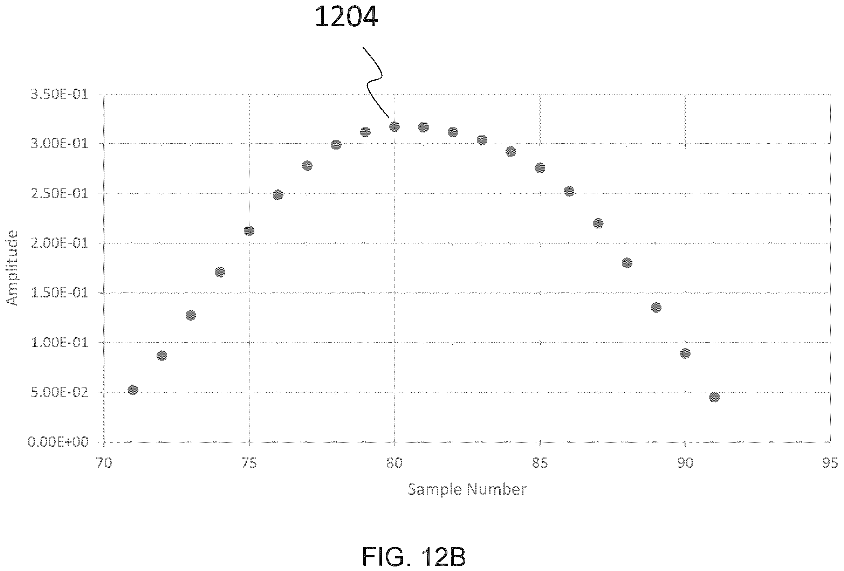

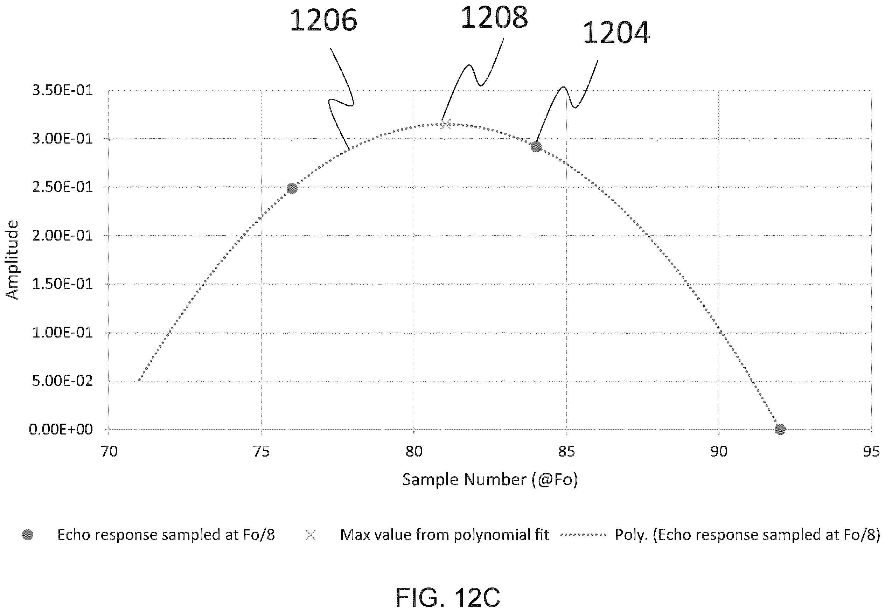

Figure 12B shows a zoomed in version of part of the reflection depicted in figure 12A. The peak sample may be sample 1204. Figure 12C, shows the same reflection sampled at a much lower sampling frequency. As it can be seen, there are gaps between the samples where no data has been collected. The true peak of the reflection may therefore be located between two of the samples.

Figure 12C also shows a polynomial approximation 1206 applied to the reflection. Figures 12A and 12B are sampled at a high frequency. The approximation is then applied to the 12C data, which is sampled at 1/8 of the Fs of Figures 12A and 12B. As can be seen, a maximum value 1208 of the polynomial function is different to the sample 1204 that was previously considered to represent the maximum value and this value is closer to the maximum 1204 from Figure 12B. The polynomial approximation 1206 therefore improves the accuracy of peak detection in a reflection. Whilst the polynomial fitting is described here with respect to a maximum value of the polynomial function, instead, where the reflection has a negative polarity, it may instead be with respect to the lowest or minimum value of the polynomial function. Put another way, the sample number for the peak of a reflection may be chosen as the sample number of interpolated sample number at which an absolute maximum value of the polynomial function occurs.

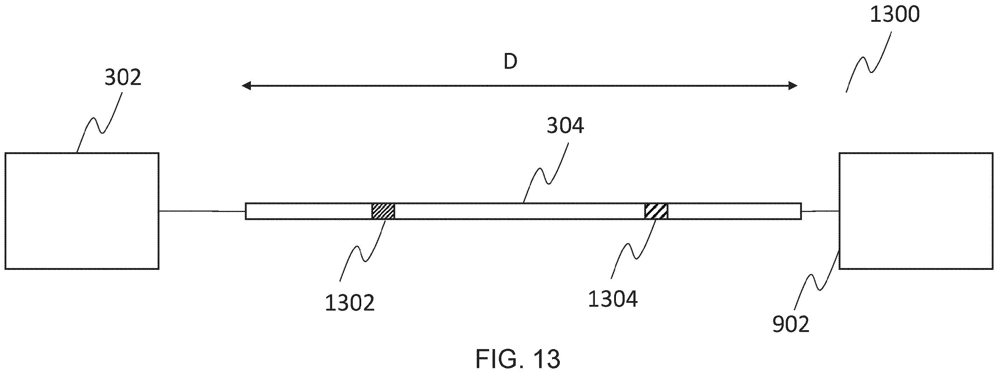

Any detected faults may be represented using a heat map, showing the location of the fault. Figure 13 shows a heat map 1300. The heat map provides graphical representation of the cable or transmission line 304. Represented on the cable or transmission line are one or more faults detected by the control systems 306. Where no faults are detected, no faults may be represented on the cable or transmission line 304. Where multiple faults are detected, each fault may be represented such that the severity of the fault is displayed. For example, fault 1302 is represented by a closely dashed area, representing a fault of a greater magnitude. Fault 1304 is represented by a different dashed area, representing a fault of a relatively lesser magnitude.

The graphical representation may be presented on a digital or information display. With the control system 306 providing instructions to the display relating to the location and severity of faults. The heat map shown in figure 13 is a black and white line-drawings. However, the heat map may be instead represented using colour. As such, the faults may be represented by an increase in colour gradient. approaching the fault and a decrease in colour gradient after the fault. The colour gradient and colour itself may be used to represent the severity of the fault, for example how far the peak of the reflection is above the fault threshold. This allows the user to quickly determine the locations and severity of faults in the cable or transmission line.

Various modifications whether by way of addition, deletion, or substitution of features may be made to the above described examples to provide further examples, any and all of which are intended to be encompassed by the appended claims.

<u>Numbered Aspects:</u>

By way of non-limiting example, some aspects of the disclosure are set out in the following numbered clauses.

1. A method of detecting a fault along a cable or transmission line, the method comprising:

obtaining an echo response of the cable or transmission line using time domain reflectometry, TDR;
identifying a plurality of reflections in the echo response;
generating a representation of the plurality of reflections;
obtaining a normalised representation of the representation of the plurality of reflections or obtaining a normalised representation of a fault threshold;
determining a fault condition based on the normalised representation and an other one of representation of the plurality of reflections or the fault threshold.

2. The method according to aspect 1, wherein obtaining the normalised representation of the representation of the plurality of reflections or the fault threshold comprises obtaining a normalised representation of the representation of the plurality of reflections, and
wherein determining a fault condition comprises determining a fault condition based on the normalised representation and the fault threshold.

3. The method according to aspect 1, wherein obtaining a normalised representation of the representation of the plurality of reflections or the fault threshold comprises obtaining a normalised representation of the fault threshold, and wherein determining a fault condition comprises determining a fault condition based on the representation of the plurality of reflections and the normalised representation of the fault threshold.

4. The method of detecting a fault along a cable according to any preceding aspect, wherein the method further comprises:
validating the plurality of reflections, wherein validating the plurality of reflections comprises determining whether a reflection of the plurality of reflections is invalid, such that it is not representative of a fault condition.

5. The method according to aspect 4, comprising determining a reflection of the plurality of reflections as invalid if the reflection is adjacent to a preceding reflection and is of an opposite polarity to the preceding reflection, wherein the reflection is adjacent to the preceding reflection if a sample of the preceding reflection is at a later time than a sample of the reflection.

6. The method according to aspect 4 or aspect 5, comprising determining a reflection of the plurality of reflections as invalid if the reflection has a width that is less, in samples, than half a width of a reflection caused by a fault occurring at zero distance from the end of the cable or transmission line.

7. The method according to any of aspects 4-6, comprising determining a reflection of the plurality of reflections as invalid if the reflection has a width that is greater than a sample width threshold.

8. The method according to any of aspects 4-7, comprising determining a reflection of the plurality of reflections as invalid if the reflection is adjacent and of an opposite polarity to a preceding reflection and has a smaller average starting differential than the preceding reflections ending differential.

9. The method according to any of aspects 4-8, wherein the method further comprises:
discarding the invalid peaks from the obtained echo response and obtaining the representation of the plurality of reflections based on any remaining reflections of the identified plurality of reflections.

10. The method according to any preceding aspect, wherein the representation of the plurality of reflections comprises either:

    a first waveform which comprises the plurality of reflections; or
    a list comprising the plurality of reflections and respective sample numbers of the plurality of validated reflections

11. The method according to aspect 10, wherein the list comprising the plurality of reflections and respective sample numbers of the plurality of reflections further comprises characteristics of the validated reflections, wherein the characteristics include one or more of:

    a width of the respective reflections;
    a maximum value of the respective reflections;
    a location of the maximum value' for the respective reflections;
    a starting point of the respective reflections;
    an ending point of the respective reflections;
    an average starting slope of the respective reflections; and
    an average ending slope of the respective reflections

12. The method according to any of aspects 2 to 11, wherein determining a fault condition comprises determining whether a reflection in the normalised representation is above the threshold.

13. The method according to any of aspects 3 to 11, wherein determining a fault condition comprises determining whether a reflection in the representation of the plurality of reflections is above the normalised representation of threshold.

14. The method according to any preceding aspect, wherein the method further comprises:
determining a location of the fault condition based on a sample number of the reflection for which the fault condition is determined.

15. The method according to any preceding aspect, wherein the method further comprises:
fitting a polynomial function to a reflection of the echo response and determining a location of the reflection based on a maximum or minimum value of the polynomial function and its sample number or interpolated sample number at which this maximum or minimum value occurs.

16. The method according to aspect 14 or aspect 15 wherein the method further comprises:
obtaining a heat map representation of the locations of fault conditions.

17. The method according to aspect 16, wherein the heat map representation further comprises one or more of the following:

a reflection coefficient of the fault condition;
a return loss of the fault condition; and
an impedance mismatch of the fault condition.

18. The method according to any preceding aspect, wherein obtaining a normalised representation comprises normalising relative to an insertion loss of the cable.

19. The method according to any preceding aspect, wherein obtaining the normalised representation comprises normalising the reflections using a single-point normalisation centred at the frequency or average frequency where the power of a transmitted signal is centred.

20. The method according to any preceding aspect, wherein obtaining a normalised representation comprises normalising using a sample dependent normalisation such that the applied normalisation is an exponential function of a sample number (n), and depends on the amplitude and sample number of the reflection corresponding to an open condition under a situation where no cable is connected occurs and the amplitude and sample number of the reflection corresponding to an open or short condition at an end of the cable, when a cable is connected.

21. The method according to aspect 20, wherein the normalisation is the function $\beta^{(n-n_0)}$, wherein $\beta$ is the cable's insertion loss per sample, n is the sample number corresponding to the sample being normalised and $n_0$ is the sample number of the first reflection in a situation whereby no cable is connected.

22. The method according to any preceding aspect, wherein the obtained echo response of the cable or transmission line is obtained through a cross correlation of a frequency shaped pseudo-random sequence of transmission symbols.

23. The method according to any preceding aspect, wherein the method further comprises:
transmitting a frequency shaped pseudo-random sequence of transmission symbols to obtain the echo response of the cable through a cross correlation.

24. The method according to aspect 23, wherein the transmitted frequency shaped pseudo-random sequence of transmission symbols has a power spectral density which is the same as, or a scaled version of, the power spectral density of a communication signal.

25. The method according to any preceding aspect, wherein the fault threshold is chosen based on a maximum reflection coefficient, a maximum impedance mismatch or a minimum return loss that can be tolerated by the cable or transmission line.

26. The method according to any preceding aspect, wherein the method further comprises:

obtaining a second echo response of the cable or transmission line, wherein the second echo response is taken from a different location than the echo response;

identifying a second plurality of reflections in the second echo response;

validating the plurality of reflections in the echo response, wherein validating the plurality of reflections comprises comparing locations of the plurality of peaks with locations of the second plurality of peaks.

27. The method according to aspect 26, wherein the method further comprises:

identifying a first reflection in the plurality of reflections;

identifying a second reflection in the second plurality of reflections;

comparing the first reflection and the second reflection to determine whether the first reflection is a valid reflection.

28. The method according to aspect 27, wherein the first reflection is a valid reflection if the first reflection and the second reflection overlap in location and have the same polarity.

29. The method according to aspect 27 or 28, wherein a normalisation coefficient which is used to obtain the normalised representation is determined in dependence on the ratio of the maximum value of the first reflection and the second reflection.

30. A method of detecting a fault along a cable or transmission line, the method comprising:

obtaining an echo response of the cable or transmission line using time domain reflectometry, TDR;

identifying a plurality of reflections in the echo response;

generating a representation of the plurality of reflections;

obtaining a normalised representation of the representation of the plurality of reflections; and

determining a fault condition based on the normalised and a fault threshold.

31. A method of detecting a fault along a cable or transmission line, the method comprising:

obtaining an echo response of the cable or transmission line using time domain reflectometry, TDR;

identifying a plurality of reflections in the echo response;

generating a representation of the plurality of reflections;

obtaining a normalised representation of a fault threshold; and

determining a fault condition based on the representation of the plurality of reflections and the normalised representation of the fault threshold.

**Claims**

1. A method of detecting a fault along a cable or transmission line, the method comprising:

obtaining an echo response of the cable or transmission line using time domain reflectometry, TDR;

identifying a plurality of reflections in the echo response;

generating a representation of the plurality of reflections;

obtaining a normalised representation of the representation of the plurality of reflections or obtaining a normalised representation of a fault threshold; and

determining a fault condition based on the normalised representation and an other one of the representation of the plurality of reflections or the fault threshold.

2. The method according to claim 1, wherein obtaining the normalised representation of the representation of the plurality of reflections or the fault threshold comprises obtaining a normalised representation of the representation of the plurality of reflections, and

wherein determining a fault condition comprises determining a fault condition based on the normalised representation and the fault threshold.

3. The method according to claim 1, wherein obtaining a normalised representation of the representation of the plurality of reflections or the fault threshold comprises obtaining a normalised representation of the fault threshold, and

wherein determining a fault condition comprises determining a fault condition based on the representation of the plurality of reflections and the normalised representation of the fault threshold.

4. The method according to any preceding claim, wherein the method further comprises:
validating the plurality of reflections, wherein validating the plurality of reflections comprises determining whether a reflection of the plurality of reflections is invalid, such that it is not representative of a fault condition.

5. The method according to claim 4, comprising determining a reflection of the plurality of reflections is invalid if:

the reflection is adjacent to a preceding reflection and is of an opposite polarity to the preceding reflection, wherein the reflection is adjacent to the preceding reflection if a sample of the preceding reflection is at a later time than a sample of the reflection; or
the reflection has a width that is less, in samples, than half a width of a reflection caused by a fault occurring at zero distance from an end of the cable or transmission line.

6. The method according to any of claims 4-5, comprising determining a reflection of the plurality of reflections is invalid if the reflection is adjacent and of an opposite polarity to a preceding reflection and has a smaller average starting differential than the preceding reflections ending differential.

7. The method according to any of claims 4-6, wherein the method further comprises:
discarding invalid peaks from the obtained echo response and obtaining the representation of the plurality of reflections based on any remaining reflections of the identified plurality of reflections.

8. The method according to any preceding claim, wherein the representation of the plurality of reflections comprises either:

a first waveform which comprises the plurality of reflections; or
a list comprising the plurality of reflections and respective sample numbers of a plurality of the reflections.

9. The method according to any of claims 2-8, wherein determining a fault condition comprises either:

determining whether a reflection in the normalised representation is above the threshold; or
determining whether a reflection in the representation of the plurality of reflections is above the normalised representation of threshold.

10. The method according to any preceding claim, wherein the method further comprises:
determining a location of the fault condition based on a sample number of the reflection for which the fault condition is determined.

11. The method according any preceding claim, wherein the method further comprises:
fitting a polynomial function to a reflection of the echo response and determining a location of the reflection based on a maximum value of the polynomial function and a sample number or interpolated sample number at which this maximum value occurs.

12. The method according to any preceding claim, wherein obtaining the normalised representation comprises normalising relative to an insertion loss of the cable.

13. The method according to any preceding claim, wherein obtaining the normalised representation comprises normalising the reflections using a single-point normalisation centred at a frequency or average frequency where power of a transmitted signal is centred.

14. The method according to any preceding claim, wherein the normalisation is a function $\beta^{(n-n_0)}$, wherein $\beta$ is an insertion loss of the cable per sample, n is a sample number corresponding to the sample being normalised and $n_0$ is a sample number of a first reflection in a situation whereby no cable is connected.

15. The method according to any preceding claim, wherein the method further comprises:

obtaining a second echo response of the cable or transmission line, wherein the second echo response is taken from a different location than the echo response;
identifying a second plurality of reflections in the second echo response;
validating the plurality of reflections in the echo response, wherein validating the plurality of reflections comprises comparing locations of a plurality of peaks with locations of the second plurality of peaks; and optionally wherein the method further comprises:

identifying a first reflection in the plurality of reflections;
identifying a second reflection in the second plurality of reflections;
comparing the first reflection and the second reflection to determine whether the first reflection is a valid reflection.

FIG. 1

2/16

FIG. 2

S412

S402 → S404 → S406 → S408 → S410

FIG. 3b

S402 → S404 → S406 → S408 → S410

FIG. 3a

FIG. 4

FIG. 5

Impulse Response for Different Cable Lengths

FIG. 6

EP 4 564 023 A1

FIG. 7a

Impulse Response

$p_m$

$m$

704

Impulse Response

Echo Sample Number

0   200   400   600   800   1000

0.00   0.05   0.10   0.15   0.20

FIG. 7b

23

800

S802

S804

S806

FIG. 8

EP 4 564 023 A1

FIG. 9

EP 4 564 023 A1

```
┌──────────┐              ┌──────────┐
│   S402   │              │  S1002   │
└────┬─────┘              └────┬─────┘
     │                         │
     ▼                         ▼
┌──────────┐   ┌──────────┐   ┌──────────┐
│   S404   │──▶│  S1012   │◀──│  S1004   │
└──────────┘   └────┬─────┘   └──────────┘
                    │
                    ▼
               ┌──────────┐
               │   S406   │
               └────┬─────┘
                    │
                    ▼
               ┌──────────┐
               │   S408   │
               └────┬─────┘
                    │
                    ▼
               ┌──────────┐
               │   S410   │
               └──────────┘
```

FIG. 10

FIG. 11

FIG. 12A

EP 4 564 023 A1

FIG. 12B

FIG. 12C

EP 4 564 023 A1

FIG. 13

EP 4 564 023 A1

Europäisches
Patentamt

European
Patent Office

Office européen
des brevets

# EUROPEAN SEARCH REPORT

**Application Number**

EP 24 21 4110

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2005/036189 A1 (ACTERNA CORP [US]) 21 April 2005 (2005-04-21) | 1-4,7-9 | INV. G01R31/08 |
| A | * page 4, line 18 - page 5, line 18 * <br> * page 14, line 1 - page 14, line 4 * <br> ----- | 5,6, 10-15 | G01R31/11 |
| A | COZZA ANDREA: "Never Trust a Cable Bearing Echoes: Understanding Ambiguities in Time-Domain Reflectometry Applied to Soft Faults in Cables", IEEE TRANSACTIONS ON ELECTROMAGNETIC COMPATIBILITY, IEEE SERVICE CENTER , NEW YORK , NY, US, vol. 61, no. 2, 1 April 2019 (2019-04-01), pages 586-589, XP011707942, ISSN: 0018-9375, DOI: 10.1109/TEMC.2018.2830404 [retrieved on 2019-01-25] * the whole document * <br> ----- | 1-15 | |
| A | US 2019/107573 A1 (BEN HASSEN WAFA [FR] ET AL) 11 April 2019 (2019-04-11) * figure 4 * <br> ----- | 1-15 | **TECHNICAL FIELDS SEARCHED (IPC)** <br><br> G01R |

The present search report has been drawn up for all claims

| Place of search | Date of completion of the search | Examiner |
|---|---|---|
| Munich | 2 April 2025 | O'Callaghan, D |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 21 4110

This annex lists the patent family members relating to the patent documents cited in the above-mentioned European search report.
The members are as contained in the European Patent Office EDP file on
The European Patent Office is in no way liable for these particulars which are merely given for the purpose of information.

02-04-2025

| Patent document cited in search report | Publication date | Patent family member(s) | Publication date |
|---|---|---|---|
| WO 2005036189 A1 | 21-04-2005 | AU 2003275025 A1<br>WO 2005036189 A1 | 27-04-2005<br>21-04-2005 |
| US 2019107573 A1 | 11-04-2019 | EP 3440472 A1<br>FR 3050036 A1<br>US 2019107573 A1<br>WO 2017174400 A1 | 13-02-2019<br>13-10-2017<br>11-04-2019<br>12-10-2017 |

EPO FORM P0459

For more details about this annex : see Official Journal of the European Patent Office, No. 12/82